(19) Europäisches Patentamt
European Patent Office
Office européen des brevets

(11) **EP 1 685 673 B1**

(12) **EUROPÄISCHE PATENTSCHRIFT**

(45) Veröffentlichungstag und Bekanntmachung des Hinweises auf die Patenterteilung:
**20.08.2008 Patentblatt 2008/34**

(21) Anmeldenummer: **04818832.0**

(22) Anmeldetag: **17.11.2004**

(51) Int Cl.:
**H04L 1/00** *(2006.01)*

(86) Internationale Anmeldenummer:
**PCT/EP2004/052996**

(87) Internationale Veröffentlichungsnummer:
**WO 2005/050901 (02.06.2005 Gazette 2005/22)**

(54) **VERFAHREN ZUR ÜBERTRAGUNG VON DIGITALEN INFORMATIONSPAKETEN IN EINEM DATENNETZ**

METHOD FOR TRANSMITTING DIGITAL INFORMATION PACKETS IN A DATA NETWORK

PROCEDE DE TRANSMISSION DE PAQUETS D'INFORMATIONS NUMERIQUES DANS UN RESEAU DE DONNEES

(84) Benannte Vertragsstaaten:
**AT BE BG CH CY CZ DE DK EE ES FI FR GB GR HU IE IS IT LI LU MC NL PL PT RO SE SI SK TR**

(30) Priorität: **19.11.2003 DE 10353974**

(43) Veröffentlichungstag der Anmeldung:
**02.08.2006 Patentblatt 2006/31**

(73) Patentinhaber: **SIEMENS AKTIENGESELLSCHAFT
80333 München (DE)**

(72) Erfinder:
• **PANDEL, Jürgen
83620 Feldkirchen-Westerham (DE)**
• **WAGNER, Marcel
80335 München (DE)**

(56) Entgegenhaltungen:
**US-A1- 2003 207 696**

• **BOYCE J M: "Packet loss resilient transmission of MPEG video over the Internet - Principles, Protocols, and Architecture" SIGNAL PROCESSING. IMAGE COMMUNICATION, ELSEVIER SCIENCE PUBLISHERS, AMSTERDAM, NL, Bd. 15, Nr. 1-2, September 1999 (1999-09), Seiten 7-24, XP004180635 ISSN: 0923-5965**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 1 685 673 B1

**Beschreibung**

Die Erfindung betrifft ein Verfahren zur Übertragung von digitalen Informationspaketen in einem Datennetz von einem Sender zu einem Empfänger sowie einen entsprechenden Sender und einen entsprechenden Empfänger.

In der digitalen Datenübertragung tritt das Problem auf, dass Daten aufgrund von schlechten Übertragungsverbindungen oder geringen Bandbreiten während der Übertragung verloren gehen. Insbesondere bei paketorientiertem Datenverkehr führen fehlerhafte bzw. verlorengegangene Daten zu einem Verlust von vollständigen Paketen, wodurch der Inhalt nicht mehr korrekt wiedergegeben werden kann. Besonders problematisch sind Datenverluste bei sog. Multimedia-Anwendungen, bei denen die Daten oftmals in Echtzeit ohne Verzögerung beim Empfänger angezeigt werden sollen.

Aus dem Stand der Technik sind sog. Broadcast- und Multicast-Datenübertragungen bekannt, bei denen Daten von einem einzigen Sender gesendet werden und von einer Vielzahl von Empfängern empfangen werden können. Bei diesen Datenübertragungen können zum Fehlerschutz sog. Reed-Solomon-Codes verwendet werden. Mit Hilfe der Reed-Solomon-Codes wird den Daten Redundanz hinzugefügt, so dass bei nicht allzu großen Datenverlusten beim Empfänger die ursprünglichen Daten rekonstruiert werden können. Bekannte Fehlerschutzverfahren mithilfe von Reed-Solomon-Codes eignen sich beispielsweise für die terrestrische Datenübertragung gemäß dem DVB-T-Standard (DVB-T = Digital Video Broadcast - Terrestrial)und dem dazu kompatiblen DVB-H-Standard (Digital Video Broadcast - Handheld). Es treten jedoch Probleme bei der Verwendung von anderen Datenübertragungsmechanismen auf. Problematisch ist insbesondere die Verwendung des zukünftigen Multimedia Broadcast/Multicast Service (MBMS), bei dem eine Broadcast-Datenübertragung über Mobilfunkkanäle ermöglicht wird, denn bei einer Datenübertragung zu einem mobilen Empfänger ist nicht gewährleistet, dass die Datenpakete in der Reihenfolge beim Empfänger eingehen, in der sie beim Sender ausgesendet wurden.

Aufgabe der Erfindung ist es deshalb, ein Verfahren zum Übertragen von digitalen Informationspaketen von einem Sender zu einem Empfänger zu schaffen, welches eine Broadcast- und Multicast-Datenübertragung für eine Vielzahl von Übertragungsnetzen ermöglicht.

Aus einer Entgegenhaltung EP 1 014 730 A1 ist eine Methode und ein System bekannt, bei dem eine Fehlervorwärtskorrektur auf einen MPEG-2 Transportstrom angewendet wird, wobei dieser eine optionale Fehlerkorrekturinformation umfasst.

Diese Aufgabe wird durch die unabhängigen Patentansprüche gelöst. Weiterbildungen der Erfindung sind in den abhängigen Ansprüchen definiert.

Bei dem erfindungsgemäßen Übertragungsverfahren werden digitale Informationspakete von einem Sender zu einem Empfänger gesendet, wobei die Informationspakete mittels einer Transportschicht transportiert werden. Unter Transportschicht ist hierbei eine Transportschicht im Sinne des OSI-Referenzmodells zu verstehen (OSI = Open Systems Interconnection). In dem Verfahren werden in einem ersten Schritt die zu übertragenden Informationspakete im Sender in ein oder mehrere Datenpaketgruppen aufgeteilt. Den Datenpaketgruppen wird dann jeweils Redundanzinformation in Form von Redundanzpaketen hinzugefügt. Anschließend werden die Informationspakete und die Redundanzpakete in den Datenpaketgruppen jeweils um ein Signalisierungsfeld ergänzt, in dem Informationen gespeichert sind, mit denen die Position des jeweiligen Informationspaketes bzw. des jeweiligen Redundanzpakets innerhalb der jeweiligen Datenpaketgruppen ermittelbar ist. In den Signalisierungsfeldern ist auch die Information enthalten, ob das jeweilige Redundanzpaket das letzte Redundanzpaket in der jeweiligen Datenpaketgruppe ist und zu welcher Datenpaketgruppe das jeweilige Informationspaket oder Redundanzpaket (RS_1, RS_2,..., RS_L) gehört. Die Datenpaketgruppen werden dann zum Empfänger übertragen und im Empfänger werden die Signalisierungsfelder der empfangenen Informationspakete und Redundanzpakete ausgelesen. Mit Hilfe der Informationen in den Signalisierungsfeldern werden schließlich die Positionen der Informationspakete und Redundanzpakete in den jeweiligen Datenpaketgruppen rekonstruiert. Die Idee der Erfindung beruht auf der Ergänzung der zu übertragenden Informationspakete bzw. Redundanzpakete um ein Signalisierungsfeld, mit dem die korrekte Positionierung der einzelnen Pakete in den Datenpaketgruppen beim Empfänger gewährleistet wird. Das Verfahren eignet sich somit auch zur Übertragung über Datennetze, bei denen Datenpakete nicht in der Reihenfolge beim Empfänger ankommen, in der sie vom Sender ausgesendet wurden.

In einer bevorzugten Ausführungsform der Erfindung ist in den Signalisierungsfeldern jeweils die Information enthalten, ob ein Informationspaket oder ein Redundanzpaket vorliegt. Ferner ist in den Signalisierungsfeldern jeweils die Information enthalten, zu welcher Datenpaketgruppe das jeweilige Informationspaket oder Redundanzpaket gehört. Diese Information ist insbesondere dann wichtig, wenn große Datenpaketverluste auftreten, so dass ganze Paketgruppen verloren gehen. In einer weiteren bevorzugten Ausführungsform der Erfindung enthalten die Signalisierungsfelder ferner die Information, ob das jeweilige Informationspaket das letzte Informationspaket in der jeweiligen Datenpaketgruppe ist. Mit Hilfe dieser Information kann in Kombination mit weiteren Informationen im Signalisierungsfeld die Größe der Datenpaketgruppe abgeleitet werden, ohne dass Parameter betreffend diese Größe direkt übertragen werden müssen.

In einer besonders bevorzugten Ausführungsform der Erfindung handelt es sich bei den Datenpaketgruppen jeweils um eine Datenmatrix mit einer Vielzahl von Datenfeldern in einer Mehrzahl von Zeilen und Spalten. Die Datenfelder sind hierbei vorzugsweise Datenoktetts, d.h. 8-Bit-Felder.

Werden die Datenpaketgruppen in Form von Datenmatrizen angeordnet, enthalten die Informationspakete und/oder die Redundanzpakete im Signalisierungsfeld vorzugsweise die Spalten- und/oder Zeilenadresse des jeweiligen Informationspakets oder Redundanzpakets in der Datenmatrix. Durch diese Adresse wird die Position des ersten Datenfeldes des entsprechenden Datenpakets in der Datenmatrix spezifiziert. Vorzugsweise nehmen die Redundanzpakete jeweils eine Zeile in der entsprechenden Datenmatrix ein, so dass es nicht mehr nötig ist, für die Redundanzpakete Spaltenadressen zu übertragen.

In einer weiteren Ausführungsform der Erfindung wird die Zeilenlänge der Datenmatrix aus der Länge eines korrekt empfangenen Redundanzpakets rekonstruiert. Ferner können ein oder mehrere Signalisierungsfelder jeweils zwei Parameter ausgewählt aus der Parametermenge umfassend die jeweilige Redundanzpaketnummer, die Zeilenadresse des jeweiligen Redundanzpakets und die Anzahl der Zeilen, in denen Informationspakete enthalten sind, enthalten und mithilfe der zwei Parameter im Signalisierungsfeld kann der Parameter der Parametermenge ermittelt werden, der nicht im Signalisierungsfeld enthalten ist. Darüber hinaus kann die Anzahl der Zeilen der Datenmatrix, die beim Empfänger für empfangene Redundanzpakete benötigt werden, mit Hilfe des korrekt empfangenen Redundanzpakets mit der höchsten Redundanzpaketnummer und dessen Zeilenadresse rekonstruiert werden.

In einer weiteren bevorzugten Ausführungsform werden die hinlänglich bekannten Reed-Solomon-Codes zur Erzeugung der Redundanzpakete verwendet. Ferner sind die Signalisierungsfelder vorzugsweise 24-Bit-Felder.

In einer weiteren Ausführungsform des erfindungsgemäßen Verfahrens wartet der Empfänger nach dem Empfang des letzten Informationspakets und des letzten Redundanzpakets einer Datenpaketgruppe eine vorgegebene Zeitspanne auf noch fehlende Informationspakete oder Redundanzpakete der Datenpaketgruppe. Hierdurch wird eine effektive Rekonstruktion insbesondere dann erreicht, wenn die Datenpakete teilweise verzögert beim Empfänger ankommen.

Das erfindungsgemäße Verfahren eignet sich insbesondere bei der Verwendung eines Mobilfunknetzes. In Mobilfunknetzen werden die Daten in der physikalischen Schicht über unterschiedliche Bearer-Services übertragen, was zu unterschiedlichen Datenverzögerungen führt, so dass die Datenpakete nicht mehr zwangsläufig in der richtigen Reihenfolge empfangen werden. Durch die Verwendung eines Signalisierungsfeldes gemäß der Erfindung kann auch in solchen Fällen eine Rekonstruktion der Datenpakete gewährleistet werden.

Neben dem erfindungsgemäßen Übertragungsverfahren betrifft die Erfindung ferner einen Sender zum Senden von digitalen Informationspaketen, der in dem erfindungsgemäßen Übertragungsverfahren verwendbar ist. Der Sender ist derart ausgestaltet, dass er folgende Verfahrensschritte ausführen kann:

- die zu übertragenden Informationspakete werden in eine oder mehrere Datenpaketgruppen aufgeteilt;
- den Datenpaketgruppen wird jeweils Redundanzinformation in Form von Redundanzpaketen hinzugefügt;
- die Informationspakete und die Redundanzpakete in den Datenpaketgruppen werden jeweils um ein Signalisierungsfeld ergänzt, in dem Informationen gespeichert sind, mit denen die Position des jeweiligen Informationspakets bzw. des jeweiligen Redundanzpakets innerhalb der jeweiligen Datenpaketgruppe ermittelbar ist, in dem die Information enthalten ist, ob das jeweilige Redundanzpaket (RS_1, RS_2, ... RS_L) das letzte Redundanzpaket in der jeweiligen Datenpaketgruppe (GM) ist, und in dem jeweils die Information enthalten ist, zu welcher Datenpaketgruppe (GM) das jeweilige Informationspaket (I_1, I_2,..., I_M) oder Redundanzpaket (RS_1, RS_2,..., RS_L) gehört;
- die Datenpaketgruppen werden zu einem Empfänger gesendet.

Die Erfindung betrifft darüber hinaus einen Empfänger zum Empfang von digitalen Informationspaketen mit Hilfe des erfindungsgemäßen Übertragungsverfahrens, wobei der Empfänger derart ausgestaltet ist, dass er folgende Verfahrensschritte ausführen kann:

- die von einem Sender gesendeten Informationspakete und Redundanzpakete werden empfangen;
- die Signalisierungsfelder der empfangenen Informationspakete und Redundanzpakete werden ausgelesen und mithilfe der Informationen in den Signalisierungsfeldern werden die Positionen der Informationspakete und Redundanzpakete in den jeweiligen Datenpaketgruppen rekonstruiert, wobei in dem die Information enthalten ist, ob das jeweilige Redundanzpaket das letzte Redundanzpaket in der jeweiligen Datenpaketgruppe ist, und in dem jeweils die Information enthalten ist, zu welcher Datenpaketgruppe das jeweilige Informationspaket oder Redundanzpaket gehört.

Ausführungsbeispiele der Erfindung werden nachfolgend anhand der beigefügten Zeichnungen beschrieben.

Es zeigen:

Figur 1    die schematische Darstellung eines Datennetzes, in dem das erfindungsgemäße Verfahren zum Einsatz kommt;

Figur 2    die in einer Ausführungsform des erfindungsgemäßen Verfahrens verwendete Datenmatrix;

Figur 3    die schematische Darstellung von zwei im erfindungsgemäßen Verfahren verwendbaren
Datenpakettypen;

Figur 4    den Aufbau eines im erfindungsgemäßen
Verfahren verwendeten Signalisierungsfeldes für ein Informationspaket; und

Figur 5    den Aufbau eines im erfindungsgemäßen
Verfahren verwendeten Signalisierungsfeldes für ein Redundanzpaket.

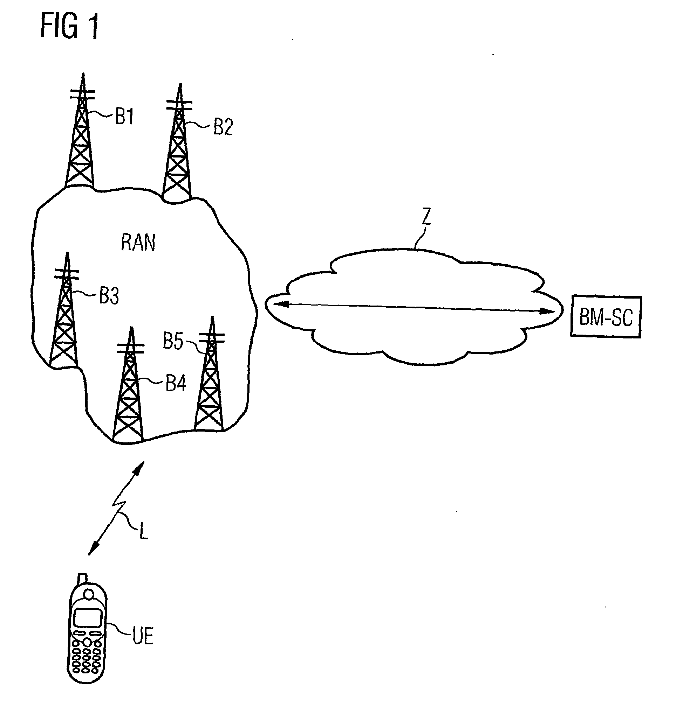

Figur 1 zeigt ein bevorzugtes Szenario, in dem das erfindungsgemäße Verfahren eingesetzt werden kann. Es handelt sich hierbei um die Übertragung von Multimediadaten eines Broadcast-Dienstes, der Daten aussendet, die gleichzeitig von mehreren Empfängern empfangen werden können. Die Multimediadaten werden von einem Broadcast-Multicast-Service-Center BM-SC bereitgestellt und über ein beliebiges Zwischennetz Z an ein Mobilfunknetz RAN (RAN = Radio Access Network) übertragen. Das Mobilfunknetz RAN umfasst eine Vielzahl von Basisstationen B1 bis B5, mittels derer über eine Luftschnittstelle L die Multimediadaten an ein Benutzerendgerät UE (UE = User Equipment) in der Form eines Handys übertragen werden.

Der BM-SC erzeugt Informationspakete, die einen Header und eine Nutzlast umfassen, wobei die Informationspakete Datenpakete sind, welche mit Hilfe einer Transportschicht gemäß dem OSI-Referenzmodell übertragen werden. Das in Figur 1 dargestellte Szenario unterscheidet sich vom Broadcast-Dienst DVB-T darin, dass zum einen eine Datenübertragung über ein Mobilfunknetz stattfindet und zum anderen der Datentransport paketorientiert über eine Transportschicht erfolgt. Bei der Übertragung über die Luftschnittstelle L tritt das Problem auf, dass beim Datentransport über mehrere unterschiedliche Mobilfunkkanäle die Daten nicht mehr zwangsläufig in der gleichen Reihenfolge ankommen, wie sie von der Basisstation gesendet wurden. Ferner treten auf den unterschiedlichen Mobilfunkkanälen Datenpaketverluste auf. Hierdurch wird eine Rekonstruktion der zum Benutzerendgerät UE gesendeten Information äußerst schwierig.

Zur Lösung dieses Problems wird gemäß der Erfindung die Hinzufügung von Redundanzinformation zu den Informationspaketen sowie die Ergänzung der Datenpakete mit einem Signalisierungsfeld vorgeschlagen, wobei das Signalisierungsfeld die Rekonstruktion der empfangenen Informationspakete in der richtigen Reihenfolge ermöglicht.

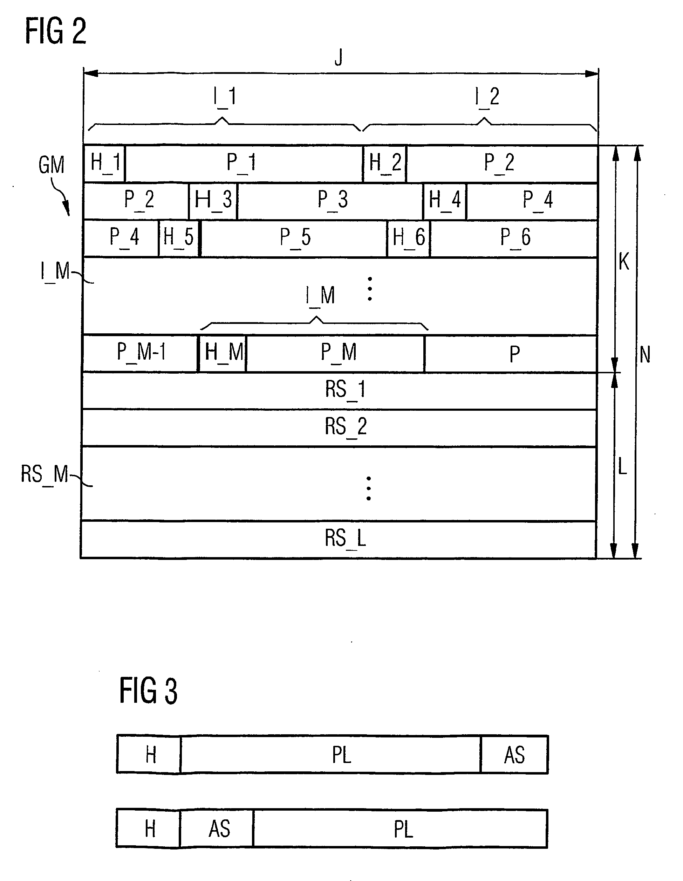

Figur 2 zeigt eine Datenmatrix, in der die Datenpakete gemäß einer Ausführungsform der Erfindung beim Sender angeordnet werden. Die zu übertragenden Daten werden zunächst in Informationspakete I_1, I_2, ... I_M segmentiert, wobei diese Segmentierung durch geeignete Protokolle auf unterschiedlichen Protokollschichten, wie z.B. RTP/UDP/IP erfolgen kann (RTP = Real Time Protocol; UDP = User Datagram Protocol; IP = Internet Protocol). Die einzelnen Informationspakete I_1 bis I_M umfassen hierbei jeweils Header H_1, H_2,..., H_M sowie Nutzlasten P_1, P_2, ...P_M.

Die Datenpakete I_1 bis I_M werden schließlich in eine Media-Datenmatrix I-M angeordnet, welche K Zeilen und J Spalten aufweist. Die einzelnen Einträge der Matrix sind hierbei Datenfelder bestehend aus 8-Bit-Symbolen. Da sich die in der Matrix I-M enthaltenen Datenpakete nicht immer exakt auf die Größe der Matrix abbilden lassen, wird die Matrix nach dem letzten, noch in die Matrix passenden Informationspaket I_M mit sog. Padding P aufgefüllt. Bevorzugt wird das Paddingfeld mit Nullen aufgefüllt.

Nach dem Anordnen der Informationspakete in der Matrix I-M werden die Informationspakete mit Redundanz belegt. Dies erfolgt spaltenweise durch die Hinzufügung von sog. Reed-Solomon-Codes, die dem Fachmann hinlänglich bekannt sind. In der hier beschriebenen Ausführungsform werden Reed-Solomon-Codes über Galois-Felder $GF(2^8)$ verwendet. Gemäß der Ausführungsform der Figur 2 werden L Zeilen von Reed-Solomon-Codes in der Form von Redundanzpaketen RS_1, RS_2, ... RS_L erzeugt, die in der Matrix RS-M angeordnet sind. Es ergibt sich auf diese Weise eine Gesamtdatenmatrix GM, die insgesamt N = K + L Zeilen aufweist.

Bei den verwendeten Reed-Solomon-Codes handelt es sich um sog. (N,K)-Codes, mit denen die ursprünglichen Daten bis zu einem Verlust von N-K Symbolen rekonstruiert werden können. Reed-Solomon-Codes sind systematische Codes, mit denen sowohl Symbolfehler als auch Symbolverluste detektiert werden, wobei im letzteren Fall die Position des Verlustes bekannt sein muss. Wenn es r Symbolverluste und s Symbolfehler in einer Datenmatrix gibt, können alle Pakete rekonstruiert werden, für die gilt:

$$2s + r \leq L.$$

Gemäß dem erfindungsgemäßen Verfahren werden die Informationspakete und die Redundanzpakete der Datenmatrix GM noch mit einem Signalisierungsfeld versehen. Figur 2 zeigt, an welchen Stellen ein solches Signalisierungsfeld in einem Informationspaket angeordnet werden kann. In Figur 2 sind zwei Alternativen dargestellt, wobei in der oberen Alternative das Signalisierungspaket AS nach dem Header H und der Nutzlast PL des Informationspakets angeordnet ist. Alternativ ist im unteren Informationspaket der Figur 2 eine Variante gezeigt, bei dem das Signalisierungsfeld AS zwischen dem Header H und der Nutzlast PL angeordnet ist. Es sind jedoch auch andere Positionen des Signalisierungsfeldes in dem Informationspaket möglich. In gleicher Weise kann das Signalisierungsfeld in den Redundanzpaketen angeordnet werden, denn diese Pakete weisen ebenfalls einen Header und eine Nutzlast auf.

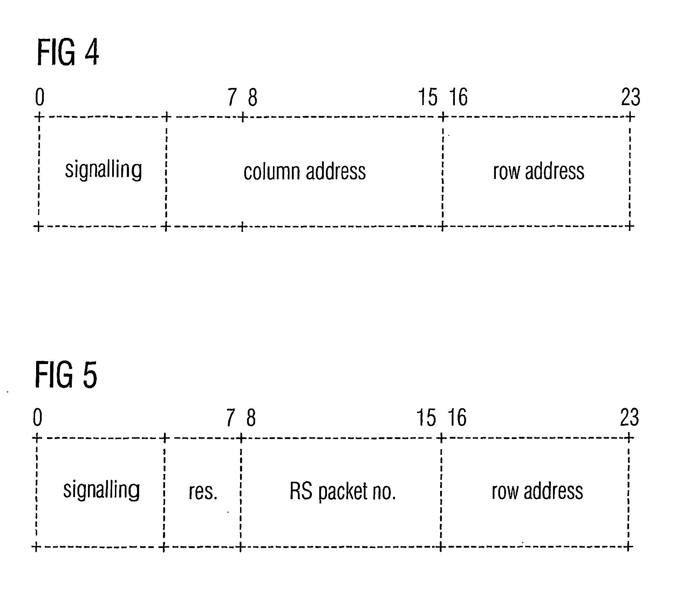

In Figur 4 ist gezeigt, wie das Signalisierungsfeld AS für ein Informationspaket gemäß einer Ausführungsform der Erfindung aufgebaut sein kann. Das AS-Feld ist ein 24-Bit-Feld, wobei die ersten fünf Bits Signalisierungsinformationen enthalten, die in Figur 4 als "signalling" bezeichnet sind. Das erste Bit dieses 5-Bit-Feldes ist ein Datentypen-Flag, das anzeigt, ob das entsprechende Paket ein Informationspaket oder ein Redundanzpaket ist. Handelt es sich um ein Informationspaket, wird das Flag auf 0 gesetzt, liegt ein Redundanzpaket vor, wird das Flag auf 1 gesetzt. Das zweite Bit des 5-Bit-Feldes ist ein Flag, das anzeigt, ob das vorliegende Datenpaket das letzte Paket in der Datenmatrix ist. Ist dies der Fall, wird das Flag auf 1 gesetzt. Die restlichen drei Bits in dem 5-Bit-Feld enthalten einen Modulo-8-Matrixzähler. Dieser Zähler zählt hoch, wenn die Datenpakete einer neuen Matrix übertragen werden. Somit zeigt der Zähler an, aus welcher Datenmatrix das entsprechende Informationspaket stammt. Der Zähler ist hilfreich, wenn große Datenpaketverluste über mehrere Datenmatrizen hinweg auftreten, da in diesem Fall immer noch festgestellt werden kann, zu welcher Datenmatrix das empfangene Informationspaket gehört. An das 5-Bit-Feld schließt sich ein 11-Bit-Feld an, mit dem die Spaltenadresse des jeweiligen Informationspakets übermittelt wird. Dieses Feld ist mit "column address" in Figur 4 bezeichnet. Die Spaltenadresse gibt hierbei die Spaltenposition des ersten Symbols des entsprechenden Pakets in der Matrix I-M an. An das Feld "column address" schließt sich das Feld "row address" an, welches ein 8-Bit-Feld ist und die Zeilenposition des ersten Symbols des entsprechenden Informationspakets in der Matrix GM angibt.

In Figur 5 ist der Aufbau des Signalisierungsfeldes für ein Redundanzpaket dargestellt. Es handelt sich wiederum um ein 24-Bit-Feld, wobei in Analogie zum Signalisierungsfeld in den Informationspaketen ein Feld "signalling" verwendet wird, das ein Datentypen-Flag, ein Flag zur Anzeige des letzten Redundanzpakets in der Matrix RS-M sowie einen Modulo-8-Matrixzähler enthält. Die Funktion dieses Feldes entspricht somit der Funktion des Feldes in Figur 4. An dieses Feld schließt sich das Feld "res." an, welches ein Reservierungsfeld darstellt und zur Signalisierung nicht benötigt wird. Zwischen Bit 8 und 15 folgt das Feld "RS packet no.", welches die Sequenznummer des Redundanzpakets innerhalb der Matrix RS-M enthält. Dieses Feld ist dann hilfreich, wenn Paketverluste zwischen der Matrix I-M und der Matrix RS-M auftreten, d.h. wenn das erste und ggf. weitere Redundanzpakete der Matrix RS-M verloren gehen. In diesem Fall kann über die Sequenznummer ermittelt werden, in welcher Zeile die Matrix RS-M anfängt. An das Feld "RS packet no." schließt sich das Feld "row address" an, welches ein 8-Bit-Feld ist und die Position des ersten Symbols des entsprechenden Redundanzpaketes in der Matrix GM anzeigt. In dem AS-Feld für die Redundanzpakete muss im Gegensatz zu dem AS-Feld für die Informationspakete nicht die Information übermittelt werden, an welcher Spaltenadresse sich das Paket befindet, da jedes Redundanzpaket in der hier beschriebenen Ausführungsform immer eine ganze Zeile einnimmt.

Nach der Erzeugung der Datenmatrix gemäß Figur 2 beim Sender werden die Informationspakete und die Redundanzpakete zum Empfänger übertragen. Die Informationspakete können dort mit Hilfe der Redundanzpakete im Fall von Paketverlusten wie folgt rekonstruiert werden:

Zur Rekonstruktion muss die Zeilenlänge J sowie die Anzahl der Spalten K der Matrix I-M bekannt sein. Da die Redundanzdatenpakete immer eine gesamte Zeile einnehmen, kann der Parameter J aus der Paketlänge der einzelnen Redundanzpakete abgeleitet werden. Der Parameter K kann wiederum aus der Zeilenadresse und der Paketnummer von einem der korrekt empfangenen Redundanzpakete abgeleitet werden.

Der Parameter L, der die Anzahl der Zeilen der Matrix RS-M angibt, muss ebenfalls nicht zum Empfänger übertragen werden. Er kann entweder über die Zeilenadresse des letzten Redundanzpaketes hergeleitet werden oder er wird durch einen kleineren Wert L' ersetzt, der der Zeile des letzten empfangenen Redundanzpaketes entspricht.

Im Empfänger werden die korrekt empfangenen Informationspakete und Redundanzpakete analysiert, wobei die Informationspakete mit Hilfe der Zeilen- und Spaltenadresse sowie des Matrixzählers im AS-Feld an die korrekte Position in der Datenmatrix positioniert werden. Anschließend werden aus den Informationspaketen die Signalisierungsfelder herausgeschnitten und der Paketlängenparameter in den Headern der Informationspakete herabgesetzt. Darüber hinaus wird das Checksum-Feld der Header neu berechnet. Ähnlich wird mit den Redundanzpaketen verfahren, wobei der Header dieser Pakete komplett entfernt wird. Wenn Pakete bei der Übertragung verlorengegangen sind, werden die entsprechenden Einträge in der Datenmatrix GM als Verluste markiert. Eine Datenmatrix kann hierbei wieder komplett wiederhergestellt werden, falls die Anzahl der Symbolverluste pro Spalte nicht größer als L ist.

Ein weiteres Problem bei der Rekonstruktion der Datenmatrix beim Empfänger resultiert daher, dass der Empfänger zunächst nicht weiß, ob ein fehlendes Datenpaket verlorengegangen ist oder ob es aufgrund unterschiedlicher Übertragungsverfahren über unterschiedliche Bearer-Services in dem Mobilfunknetz zeitlich verzögert ist. Um diesem Problem zu begegnen, wird gemäß der hier beschriebenen Ausführungsform des erfindungsgemäßen Verfahrens nach dem Empfang des letzten Informationspakets und dem Empfang des letzten Redundanzpakets eine vorbestimmte Zeitspanne gewartet, bis die Datenmatrix weiterverarbeitet wird. Somit werden in der Datenmatrix auch noch verzögert an dem Empfänger ankommende Datenpakete berücksichtigt. Sollte jedoch das letzte Informationspaket in der Datenmatrix verlorengegangen sein, besteht für den Empfänger keine Möglichkeit herauszufinden, wie groß das Padding P in der Matrix I-M ist, da die Größe des letzten Datenpakets nicht bekannt ist. In diesem Fall müssen alle Symbole nach dem letzten korrekt empfangenen Informationsdatenpaket bis zum Ende der Zeile K als Datenpaketverluste markiert werden, obwohl hierin auch Padding enthalten sein kann.

**Patentansprüche**

1. Verfahren zur Übertragung von digitalen Informationspaketen (I_1, I_2,..., I_M) in einem Datennetz von einem Sender (BM-SC) zu einem Empfänger (UE), wobei die Informationspakete mittels einer Transportschicht transportiert werden, **gekennzeichnet durch** folgende Schritte:

    - die zu übertragenden Informationspakete (I_1, I_2,..., I_M) werden im Sender (BM-SC) in eine oder mehrere Datenpaketgruppen (GM) aufgeteilt;
    - den Datenpaketgruppen (GM) wird jeweils Redundanzinformation in Form von Redundanzpaketen (RS_1, RS_2,..., RS_L) hinzugefügt;
    - die Informationspakete (I_1, I_2,..., I_M) und die Redundanzpakete (RS_1, RS_2,..., RS_L) in den Datenpaketgruppen (GM) werden jeweils um ein Signalisierungsfeld (AS) ergänzt, in dem Informationen gespeichert sind, mit denen die Position des jeweiligen Informationspakets (I_1, I_2,..., I_M) bzw. des jeweiligen Redundanzpakets (RS_1, RS_2,..., RS_L) innerhalb der jeweiligen Datenpaketgruppe (GM) ermittelbar ist, in dem die Information enthalten ist, ob das jeweilige Redundanzpaket (RS_1, RS_2, ... RS_L) das letzte Redundanzpaket in der jeweiligen Datenpaketgruppe (GM) ist, und in dem jeweils die Information enthalten ist, zu welcher Datenpaketgruppe (GM) das jeweilige Informationspaket (I_1, I_2,..., I_M) oder Redundanzpaket (RS_1, RS_2,..., RS_L) gehört;
    - die Datenpaketgruppen (GM) werden zum Empfänger (UE) übertragen;
    - im Empfänger (UE) werden die Signalisierungsfelder (AS) der empfangenen Informationspakete (I_1, I_2,..., I_M) und Redundanzpakete (RS_1, RS_2,..., RS_L) ausgelesen und mithilfe der Informationen in den Signalisierungsfeldern (AS) werden die Positionen der Informationspakete (I_1, I_2,..., I_M) und Redundanzpakete (RS_1, RS_2,..., RS_L) in den jeweiligen Datenpaketgruppen (GM) rekonstruiert.

2. Verfahren nach Anspruch 1, bei dem in den Signalisierungsfeldern (AS) jeweils die Information enthalten ist, ob ein Informationspaket (I_1, I_2,..., I_M) oder ein Redundanzdatenpaket (RS_1, RS_2,..., RS_L) vorliegt.

3. Verfahren nach einem der vorhergehenden Ansprüche, bei dem in den Signalisierungsfeldern die Information enthalten ist, ob das jeweilige Informationspaket (I_1, I_2,..., I_M) das letzte Informationspaket in der jeweiligen Datenpaketgruppe (GM) ist.

4. Verfahren nach einem der vorhergehenden Ansprüche, bei dem die Datenpaketgruppen jeweils in der Form einer Datenmatrix (GM) mit einer Vielzahl von Datenfeldern in einer Mehrzahl von Zeilen (K) für die Informationspakete und einer Mehrzahl von Zeilen (L) für die Redundanzpakete sowie einer Mehrzahl von Spalten (J) für Informations-und Redundanzpakete angeordnet sind.

5. Verfahren nach Anspruch 4, bei dem die Datenfelder 8-Bit-Felder sind.

6. Verfahren nach Anspruch 4 oder 5, bei dem die Informationspakete (I_1, I_2,..., I_M) und/oder die Redundanzpakete (RS_1, RS_2,..., RS_L) im Signalisierungsfeld (AS) die Spalten- und/oder Zeilenadresse des jeweiligen Informationspakets (I_1, I_2,..., I_M) oder Redundanzpakets RS_1, RS_2,..., RS_L) in der Datenmatrix enthält.

7. Verfahren nach einem der Ansprüche 4 bis 6, bei dem die Redundanzpakete (RS_1, RS_2,..., RS_L) jeweils eine Zeile in der entsprechenden Datenmatrix (GM) einnehmen.

8. Verfahren nach einem der Ansprüche 4 bis 7, bei dem die Zeilenlänge (J) der Datenmatrix (GM) aus der Länge eines korrekt empfangenen Redundanzpakets (RS_1, RS_2,..., RS_L) rekonstruiert wird.

9. Verfahren nach einem der Ansprüche 4 bis 8 in Kombination mit Anspruch 6, bei dem ein oder mehrere Signalisierungsfelder (AS) jeweils zwei Parameter ausgewählt aus der Parametermenge umfassend die jeweilige Redundanzpaketnummer, die Zeilenadresse des jeweiligen Redundanzpakets (RS_1, RS_2,..., RS_L) und die Anzahl der Zeilen (K), in denen Informationspakete enthalten sind, enthalten und mithilfe der zwei Parameter im Signalisierungsfeld (AS) der Parameter der Parametermenge ermittelt wird, der nicht im Signalisierungsfeld (AS) enthalten ist.

10. Verfahren nach Anspruch 9, bei dem die Anzahl der Zeilen der Datenmatrix (GM), die beim Empfänger für empfangene Redundanzpakete (RS_1, RS_2,...,

RS_L) benötigt werden, mit Hilfe des korrekt empfangenen Redundanzpakets mit der höchsten Redundanzpaketnummer und dessen Zeilenadresse rekonstruiert wird.

11. Verfahren nach einem der vorhergehenden Ansprüche, bei dem die Redundanzpakete (RS_1, RS_2,..., RS_L) Reed-Solomon-Codes umfassen.

12. Verfahren nach einem der vorhergehenden Ansprüche, bei dem die Signalisierungsfelder (AS) 24-bit-Felder sind.

13. Verfahren nach einem der vorhergehenden Ansprüche, bei dem der Empfänger (UE) nach dem Empfang des letzten Informationspakets (I_1, I_2,..., I_M) und des letzten Redundanzpakets (RS_1, RS_2,..., RS_L) einer Datenpaketgruppe (GM) eine vorgegebene Zeitspanne auf noch fehlende Informationspakete (I_1, I_2,..., I_M) oder Redundanzpakete (RS_1, RS_2,..., RS_L) der Datenpaketgruppe (GM) wartet.

14. Verfahren nach einem der vorhergehenden Ansprüche, bei dem das Datennetz ein Mobilfunknetz umfasst.

15. Sender zum Senden von digitalen Informationspaketen in einem Verfahren nach einem der vorhergehenden Ansprüche, wobei der Sender (BM-SC) derart ausgestaltet ist, dass er folgende Verfahrensschritte ausführen kann:

die zu übertragenden Informationspakete (I_1, I_2,..., I_M) werden in eine oder mehrere Datenpaketgruppen (GM) aufgeteilt;
den Datenpaketgruppen (GM) wird jeweils Redundanzinformation in Form von Redundanzpaketen (RS_1, RS_2,..., RS_L) hinzugefügt;
die Informationspakete (I_1, I_2,..., I_M) und die Redundanzpakete (RS_1, RS_2,..., RS_L) in den Datenpaketgruppen (GM) werden jeweils um ein Signalisierungsfeld (AS) ergänzt, in dem Informationen gespeichert sind, mit denen die Position des jeweiligen Informationspakets (I_1, I_2,..., I_M) bzw. des jeweiligen Redundanzpakets (RS_1, RS_2,..., RS_L) innerhalb der jeweiligen Datenpaketgruppe (GM) ermittelbar ist, in dem die Information enthalten ist, ob das jeweilige Redundanzpaket (RS_1, RS_2, ... RS_L) das letzte Redundanzpaket in der jeweiligen Datenpaketgruppe (GM) ist, und in dem jeweils die Information enthalten ist, zu welcher Datenpaketgruppe (GM) das jeweilige Informationspaket (I_1, I_2,..., I_M) oder Redundanzpaket (RS_1, RS_2,..., RS_L) gehört;
die Datenpaketgruppen (GM) werden zu einem Empfänger (UE) gesendet.

16. Empfänger zum Empfang von digitalen Informationspaketen in einem Verfahren nach einem der Ansprüche 1 bis 15, wobei der Empfänger (UE) derart ausgestaltet ist, dass er folgende Verfahrensschritte ausführen kann:

die von einem Sender gesendeten Informationspakete (I_1, I_2,..., I_M) und Redundanzpakete (RS_1, RS_2,..., RS_L) werden empfangen;

die Signalisierungsfelder (AS) der empfangenen Informationspakete (I_1, I_2,..., I_M) und Redundanzpakete (RS_1, RS_2,..., RS_L) werden ausgelesen und mithilfe der Informationen in den Signalisierungsfeldern (AS) werden die Positionen der Informationspakete (I_1, 1_2,..., I_M) und Redundanzpakete (RS_1, RS_2,..., RS_L) in den jeweiligen Datenpaketgruppen (GM) rekonstruiert, in dem die Information enthalten ist, ob das jeweilige Redundanzpaket (RS_1, RS_2, ... RS_L) das letzte Redundanzpaket in der jeweiligen Datenpaketgruppe (GM) ist, und in dem jeweils die Information enthalten ist, zu welcher Datenpaketgruppe (GM) das jeweilige Informationspaket (I_1, I_2,..., I_M) oder Redundanzpaket (RS_1, RS_2,..., RS_L) gehört.

**Claims**

1. Method for transmission of digital information packets (I_1, I_2,..., I_M) in a data network from an emitter (BM-SC) to a receiver (UE), with the information packets being transported by means of a transport layer, **characterised by** the following steps:

- The information packets to be transmitted (I_1, I_2,..., I_M) are divided up in the emitter (BM-SC) into one or more data packet groups (GM);
- Redundancy information in the form of redundancy packets (RS_1, RS_2,..., RS_L) is inserted into the data packet groups (GM) in each case;
- The information packets (I_1, I_2,..., I_M) and the redundancy packets (RS_1, RS_2,..., RS_L) in the data packet groups (GM) are each supplemented by a signalisation field (AS) in which information is stored with which the position of the relevant information packet (I_1, 1_2,..., I_M) or of the relevant redundancy packet (RS_1, RS_2,..., RS_L) within the relevant data packet group (GM) can be determined, and in which the information is contained as to whether the relevant redundancy packet (RS_1, RS_2,..., RS_L) is the last redundancy packet in the relevant data packet group (GM) and in which the information is contained about the data packet group (GM) to which the relevant information packet (I_1, I_2,..., I_M) or redundancy packet (RS_1, RS_2,..., RS_L) belongs;
- The data packet groups (GM) are transmitted to the receiver (UE);
- In the receiver (UE) the signalisation fields (AS) of the received information packets (I_1, I_2,..., I_M) and redundancy packets (RS_1, RS_2,..., RS_L) are read out and with the aid of the information in the signalisation fields (AS) the positions of the information packets (I_1, I_2,..., I_M) and redundancy packets (RS_1, RS_2,..., RS_L) in the relevant data packet groups (GM) are reconstructed.

2. Method in accordance with claim 1, in which the information is contained in the signalisation fields (AS) in each case indicating whether an information packet (I_1, I_2,..., I_M) or a redundancy packet (RS_1, RS_2,..., RS_L) is present.

3. Method in accordance with one of the previous claims, in which the information is contained in the signalisation fields as to whether the relevant information packet (I_1, I_2,..., I_M) is the last information packet in the relevant data packet group (GM).

4. Method in accordance with one of the previous claims, in which the data packet groups are arranged in each case in the form of a data matrix (GM) with a plurality of data fields in a plurality of rows (K) for the information packets and a plurality of rows (L) for the redundancy packets as well as a plurality of columns (J) for information and redundancy packets.

5. Method in accordance with claim 5, in which the data fields are 8-bit fields.

6. Method in accordance with claim 4 or 5, in which the information packets (I_1, I_2,..., I_M) and/or the redundancy packets (RS_1, RS_2,..., RS_L) contain in the signalisation field (AS) the column and/or row address of the relevant information packet (I_1, I_2,..., I_M) or redundancy packet RS_1, RS_2 ,..., RS_L) in the data matrix.

7. Method in accordance with one of the claims 4 to 6, in which the redundancy packets (RS_1, RS_2,..., RS_L) occupy one row of the corresponding data matrix (GM) in each case.

8. Method in accordance with one of the claims 4 to 7, in which the row length (J) of the data matrix (GM) is reconstructed from the length of a correctly received redundancy packet (RS_1, RS_2,..., RS_L).

9. Method in accordance with one of the claims 4 to 8 in combination with claim 6, in which one or more signalisation fields (AS), each comprising two parameters selected from the parameter set comprising the relevant redundancy packet number, contain the row address of the relevant redundancy packet (RS_1, RS_2,..., RS_L) and the number of rows (K), in which information packets are contained, and with the aid of the two parameters in the signalisation field (AS), the parameter of the parameter set is determined which is not contained in the signalisation field (AS).

10. Method in accordance with claim 9, in which the number of the rows of the data matrix (GM) which are needed at the receiver for received redundancy packets (RS_1, RS_2,..., RS_L) is reconstructed with the aid of the correctly received redundancy packets with the highest redundancy packet number and its row address.

11. Method in accordance with one of the previous claims, in which the redundancy packets (RS_1, RS_2,..., RS_L) comprise Reed-Solomon codes.

12. Method in accordance with one of the previous claims, in which the signalisation fields (AS) are 24-bit fields.

13. Method in accordance with one of the previous claims, in which the receiver (UE), after receiving the last information packet (I_1, I_2,..., I_M) and the last redundancy packet (RS_1, RS_2,..., RS_L) of a data packet group (GM), waits for a predetermined interval for outstanding information packets (I_1, I_2,..., I_M) or redundancy packets (RS_1, RS_2,..., RS_L) of the data packet group (GM).

14. Method in accordance with one of the previous claims, in which the data network comprises a mobile radio network.

15. Emitter for sending digital information packets in a method in accordance with one of the previous claims, with the emitter (BM-SC) being embodied to enable it to carry out the following steps:

- The information packets to be transmitted (I_1, I_2,..., I_M) are divided up into one or more data packet groups (GM);
- Redundancy information in the form of redundancy packets (RS_1, RS_2,..., RS_L) is inserted into the data packet groups (GM) in each case;
- The information packets (I_1, I_2,..., I_M) and the redundancy packets (RS_1, RS_2,..., RS_L) in the data packet groups (GM) are each supplemented by a signalisation field (AS) in which information is stored with which the position of the relevant information packet (I_1, I_2,..., I_M) or of the relevant redundancy packet (RS_1, RS_2,..., RS_L) within the relevant data packet group (GM) can be determined, and in which the information is contained as to whether the relevant redundancy packet (RS_1, RS_2,..., RS_L) is the last redundancy packet in the relevant data packet group (GM) and in which the information is contained in each case about the data packet group (GM) to which the relevant information packet (I_1, I_2,..., I_M) or redundancy packet (RS_1, RS_2,..., RS_L) belongs .
- The data packet groups (GM) are sent to a receiver (UE).

16. Receiver for receiving digital information packets in a method in accordance with one of the claims 1 to 15, with the receiver (UE) being embodied to enable it to carry out the following steps:

- The information packets (I_1, I_2,..., I_M) and redundancy packets (RS_1, RS_2,..., RS_L) sent by an emitter are received;
- The signalisation fields (AS) of the received information packets (I_1, I_2,..., I_M) and redundancy packets (RS_1, RS_2,..., RS_L) are read out, and with the aid of the information in the signalisation fields (AS), the positions of the information packets (I_1, I_2,..., I_M) and redundancy packets (RS_1, RS_2,..., RS_L) in the relevant data packet groups (GM) are reconstructed, with the signalisation fields containing information indicating whether the relevant redundancy packet (RS_1, RS_2,..., RS_L) is the last redundancy packet in the relevant data packet group (GM)and in which information is contained in each case about the data packet group (GM) to which the relevant information packet I_1, I_2,..., I_M) or redundancy packet (RS_1, RS_2,..., RS_L) belongs.

**Revendications**

1. Procédé pour la transmission de paquets d'information (I_1, I_2,..., I_M) numériques dans un réseau de données d'un émetteur (BM-SC) à un récepteur (UE), les paquets d'information étant transportés au moyen d'une couche de transport, **caractérisé par** les étapes suivantes :

- les paquets d'informations (I_1, I_2, ..., I_M) à transmettre sont subdivisés dans l'émetteur (BM-SC) en un ou plusieurs groupes de paquets de données (GM) ;
- à chaque fois de l'information de redondance sous la forme de paquets de redondance (RS_1, RS_2, ..., RS_L) est ajoutée aux groupes de paquets de données (GM) ;
- les paquets d'information (I_1, I_2, ..., I_M) et les paquets de redondance (RS_1, RS_2, RS_L) dans les groupes de paquets de données (GM) sont complétés chacun d'un champ de signalisation (AS), dans lequel sont stockées des informations qui permettent de déterminer la position du paquet d'information respectif (I_1, I_2, ..., I_M) respectivement du paquet de redondance (RS_1, RS_2, ..., RS_L) respectif à l'intérieur du groupe de paquets de données (GM) respectif, dans lequel est contenue l'information destinée à savoir si le paquet de redondance (RS_1, RS_2, ..., RS_L) respectif est le dernier paquet de redondance dans le groupe de paquets de données (GM) respectif, et dans lequel est contenue à chaque fois l'information destinée à savoir à quel groupe de paquets de données (GM) appartient le paquet d'information (I_1, I_2,..., I_M) ou le paquet de redondance (RS_1, RS_2, ..., RS_L) respectif ;
- les groupes de paquets de données (GM) sont transmis au récepteur (UE) ;
- dans le récepteur (UE), les champs de signalisation (AS) des paquets d'informations (I_1, I_2,..., I_M) et paquets de redondance (RS_1, RS_2, ..., RS_L) reçus sont lus et les positions des paquets d'informations (I_1, I_2, ..., I_M) et paquets de redondance (RS_1, RS_2, ..., RS_L) sont reconstituées dans les groupes de paquets de données (GM) respectifs à l'aide des informations dans les champs de signalisation (AS).

2. Procédé selon la revendication 1, dans lequel à chaque fois les champs de signalisation (AS) contiennent l'information destinée à savoir si un paquet d'information (I_1, I_2, ..., I_M) ou un paquet de données de redondance (RS_1, RS_2, ..., RS_L) est présent.

3. Procédé selon l'une quelconque des revendications précédentes, dans lequel les champs de signalisation contiennent l'information destinée à savoir si le paquet d'information (I_1, I_2, ..., I_M) respectif est le dernier paquet d'information dans le groupe de paquets de données (GM) respectif.

4. Procédé selon l'une quelconque des revendications précédentes, dans lequel les groupes de paquets de données sont disposés à chaque fois sous la forme d'une matrice de données (GM) avec une pluralité de champs de données dans une pluralité de lignes (K) pour les paquets d'information et une pluralité de lignes (L) pour les paquets de redondance ainsi qu'une pluralité de colonnes (J) pour des paquets d'information et de redondance.

5. Procédé selon la revendication 4, dans lequel les champs de données sont des champs de 8 bits.

**6.** Procédé selon la revendication 4 ou 5, dans lequel les paquets d'information (I_1, I_2, ..., I_M) et/ou les paquets de redondance (RS_1, RS_2, ..., RS_L) dans le champ de signalisation (AS) contiennent l'adresse de colonne et/ou de ligne du paquet d'information (I_1, I_2, ..., I_M) ou du paquet de redondance (RS_1, RS_2, ..., RS_L) respectif dans la matrice de données.

**7.** Procédé selon l'une quelconque des revendications 4 à 6, dans lequel les paquets de redondance (RS_1, RS_2, ..., RS_L) occupent à chaque fois une ligne dans la matrice de données (GM) correspondante.

**8.** Procédé selon l'une quelconque des revendications 4 à 7, dans lequel la longueur de ligne (J) de la matrice de données (GM) est reconstituée à partir de la longueur d'un paquet de redondance (RS_1, RS_2, ..., RS_L) reçu correctement.

**9.** Procédé selon l'une quelconque des revendications 4 à 8 en combinaison avec la revendication 6, dans lequel un ou plusieurs champs de signalisation (AS) contiennent chacun deux paramètres sélectionnés dans l'ensemble de paramètres comprenant le numéro de paquet de redondance respectif, l'adresse de ligne du paquet de redondance (RS_1, RS_2, ..., RS_L) respectif et le nombre des lignes (K) qui contiennent des paquets d'information et le paramètre de l'ensemble de paramètres, qui n'est pas contenu dans le champ de signalisation (AS), est déterminé à l'aide des deux paramètres dans le champ de signalisation (AS).

**10.** Procédé selon la revendication 9, dans lequel le nombre des lignes de la matrice de données (GM), qui sont utilisées chez le récepteur pour des paquets de redondance (RS_1, RS_2, ..., RS_L) reçus, est reconstitué à l'aide du paquet de redondance correctement reçu avec le numéro maximum de paquet de redondance et son adresse de ligne.

**11.** Procédé selon l'une quelconque des revendications précédentes, dans lequel les paquets de redondance (RS_1, RS_2, ..., RS_L) comprennent des codes de Reed-Solomon.

**12.** Procédé selon l'une quelconque des revendications précédentes, dans lequel les champs de signalisation (AS) sont des champs de 24 bits.

**13.** Procédé selon l'une quelconque des revendications précédentes, dans lequel le récepteur (UE) attend après la réception du dernier paquet d'information (I_1, I_2, ..., I_M) et du dernier paquet de redondance (RS_1, RS_2, ..., RS_L) d'un groupe de paquets de données (GM) pendant un laps de temps prédéfini des paquets d'information (I_1, I_2, ..., I_M) ou des paquets de redondance (RS_1, RS_2, ..., RS_L) encore manquants du groupe de paquets de données (GM).

**14.** Procédé selon l'une quelconque des revendications précédentes, dans lequel le réseau de données comporte un réseau de téléphonie mobile.

**15.** Emetteur pour l'envoi de paquets d'informations numériques dans un procédé selon l'une quelconque des revendications précédentes, l'émetteur (BM-SC) étant conçu de telle sorte qu'il peut exécuter les étapes de procédé suivantes :

les paquets d'informations (I_1, I_2, ..., I_M) à transmettre sont divisés en un ou plusieurs groupes de paquets de données (GM),
à chaque fois de l'information de redondance sous la forme de paquets de redondance (RS_1, RS_2, ..., RS_L) est ajoutée aux groupes de paquets de données (GM) ;
les paquets d'informations (I_1, I_2, ..., I_M) et les paquets de redondance (RS_1, RS_2, ..., RS_L) dans les groupes de paquets de données (GM) sont complétés à chaque fois d'un champ de signalisation (AS) dans lequel sont stockées des informations qui permettent de déterminer la position du paquet d'information (I_1, I_2, ..., I_M) respectivement du paquet de redondance (RS_1, RS_2, ..., RS_L) respectif à l'intérieur du groupe de paquets de données (GM) respectif, dans lequel est contenue l'information destinée à savoir si le paquet de redondance (RS_1, RS_2, ..., RS_L) respectif est le dernier paquet de redondance dans le groupe de paquets de données (GM) respectif, et dans lequel est contenue à chaque fois l'information destinée à savoir à quel paquet de groupes de données (GM) appartient le paquet d'information (I_1, I_2, ..., I_M) respectif ou le paquet de redondance (RS_1, RS_2, ..., RS_L) respectif ;
les groupes de paquets de données (GM) sont envoyés à un récepteur (UE).

**16.** Récepteur destiné à la réception de paquets d'information numériques dans un procédé selon l'une quelconque des revendications 1 à 15, le récepteur (UE) étant conçu de telle sorte qu'il peut exécuter les étapes de procédé suivantes :

les paquets d'information (I_1, I_2, ..., I_M) et les paquets de redondance (RS_1, RS_2, ..., RS_L) envoyés par un émetteur sont reçus ;
les champs de signalisation (AS) des paquets d'information (I_1, I_2, ..., I_M) et des paquets de redondance (RS_1, RS_2, ..., RS_L) reçus sont lus et les positions des paquets d'information (I_1, I_2, ..., I_M) et paquets de redondance (RS_1, RS_2, ..., RS_L) sont reconstituées dans les groupes de paquets de données respectifs à l'aide des informations dans les champs de signalisation (AS), dans lequel est contenue l'information destinée à savoir si le paquet de redondance (RS_1, RS_2, ..., RS_L) respectif est le dernier paquet de redondance dans le groupe de paquets de données (GM) respectif, et dans lequel est contenue à chaque fois l'information destinée à savoir à quel groupe de paquets de données (GM) appartient le paquet d'information (I_1, I_2, ..., I_M) ou le paquet de redondance (RS_1, RS_2, ..., RS_L) respectif.

FIG 1

FIG 2

FIG 3

# FIG 4

```
0                       7 8                    15 16                  23
+ ----------- + ------- + ------------------- + ------------------- +
|             |         |                     |                     |
|  signalling |         |   column address    |     row address     |
|             |         |                     |                     |
+ ----------- + ------- + ------------------- + ------------------- +
```

# FIG 5

```
0                       7 8                    15 16                  23
+ ----------- + ------- + ------------------- + ------------------- +
|             |         |                     |                     |
|  signalling |  res.   |   RS packet no.     |     row address     |
|             |         |                     |                     |
+ ----------- + ------- + ------------------- + ------------------- +
```

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1014730 A1